# EUROPÄISCHE PATENTSCHRIFT

(11) **EP 0 620 798 B1**
(45) Veröffentlichungstag und Bekanntmachung des Hinweises auf die Patenterteilung: **26.07.1995**
(21) Anmeldenummer: 93901634.1
(22) Anmeldetag: 13.01.1993
(51) Int. Cl.: B65G 15/58, B65G 15/48, B65G 49/05

(54) **TRANSPORTEINRICHTUNG**
CONVEYOR
CONVOYEUR

(30) Priorität: 17.01.1992 DE 4201117
(43) Veröffentlichungstag der Anmeldung: 26.10.1994
(73) Patentinhaber: SILLNER, Kamilla, D-93197 Zeitlarn (DE)
(72) Erfinder: SILLNER, Georg, D-93197 Zeitlarn (DE)
(74) Vertreter: Graf, Helmut, Dipl.-Ing.
(86) Internationale Anmeldenummer: DE9300021
(87) Internationale Veröffentlichungsnummer: WO9314009

(56) Entgegenhaltungen:
- AT-B- 339 202
- CH-A- 517 633
- US-A- 3 513 963
- PATENT ABSTRACTS OF JAPAN, unexamined applications, Sektion 5, Band 15, Nr. 53,07. Februar 1991, THE PATENT OFFICE JAPANESE GOVERNMENT Seite 149 M 1079

## Beschreibung

Die Erfindung bezieht sich auf eine Vorrichtung gemäß Oberbegriff Patentanspruch 1.

Bekannt ist eine Transporteinrichtung zum Transportieren von langgestreckten Elementen (US-A- 35 13 963). Diese Transporteinrichtung besitzt ein über wenigstens zwei Umlenkräder geführtes und eine in sich geschlossene Schlaufe bildendes Transportmittel, welches von einem Metallband gebildet ist. An dem Metallband sind klotzartige Träger mit Halter für die Bauelemente vorgesehen, und zwar derart, daß jedem Träger an einer Seite des Metallbandes ein entsprechender Träger an der anderen Seite des Metallbandes direkt gegenüberliegt.

Bekannt ist weiterhin eine Transporteinrichtung (DE-PS 12 31 624), die als Förderer für Platten oder Scheiben, insbesondere Glasscheiben dient und bei der das Transportmittel von zwei Ketten, die in zwei parallelen und voneinander beabstandeten vertikalen Ebenen jeweils eine geschlossene Schlaufe bilden und umlaufend angetrieben sind, sowie von leistenartigen Mitnehmern oder Träger gebildet ist, die jeweils beidendig an einer Kette gehalten sind und sich senkrecht zu der Ebene der von den Ketten gebildeten Schlaufen erstrecken. An den Trägern sind als Saugnäpfe ausgebildete Halter befestigt, die gegenüber dem Transportmittel verschiebbar sind und zum Aufnehmen und Halten der Platten dienen.

Besondere Anforderungen an die Präzision der Bewegung der Halter wird bei dieser bekannten Transporteinrichtung nicht gefordert und läßt sich auch schon deswegen nicht erreichen, weil die das Transportmittel bildenden Ketten schon durch die gelenkige Verbindung einer Vielzahl von Kettengliedern in Längs- bzw. Transportrichtung ein relativ großes Spiel und damit eine relativ große Ungenauigkeit bedingen. Die hierbei auftretenden Fehler sind auch noch davon abhängig, an welcher Position sich der jeweilige Halter beispielsweise bezogen auf ein angetriebenes Umlenkrad gerade befindet.

Bekannt ist weiterhin grundsätzlich auch die Herstellung eines Metalltransportbandes aus rostfreiem Stahl und das Verschweißen der beiden Enden, zur Bildung eines endlosen Transportbandes (DE-OS 31 09 797).

Aufgabe der Erfindung ist es, eine Transporteinrichtung aufzuzeigen, die trotz einer einfachen konstruktiven Ausgestaltung eine Bewegung der Halterung entlang der Transportstrecke mit hoher Genauigkeit ermöglicht.

Zur Lösung dieser Aufgabe ist eine Transporteinrichtung entsprechend dem kennzeichnenden Teil des Patentanspruches 1 ausgebildet.

Durch die Verwendung eines Metallbandes, vorzugsweise eines Stahlbandes, welches keinen oder keinen merklichen elastischen Längungen unterliegt, kann auch bei relativ großer Länge der Transportstrecke eine sehr exakte Positionierung der Halter beispielsweise an entlang des Transporteurs gebildeten Arbeitsstationen erfolgen, ohne daß hierbei für eine exakte Positionierung eine gesonderte Indexierung der Halter oder Träger an den einzelnen Arbeitsbereichen bzw. -stationen erforderlich ist. Das Metallband mit den Trägern und den dort vorgesehenen Haltern läßt sich auch besonders einfach herstellen. Dadurch, daß die Träger an der Außenseite des Metallbandes und die jeweilige Halteeinrichtung mit ihrer konvex gekrümmten Anlagefläche an der Innenseite des Metallbandes vorgesehen sind, ist dieses Metallband auch über die Umlenkräder führbar, ohne daß Knicke im Metallband auftreten.

Bei einer bevorzugten Ausführungsform bilden die Halteelemente, die beispielsweise Ansätzen und an diesen vorgesehene hülsen- oder stiftartige Elemente sind, gleichzeitig eine in Ausnehmungen in wenigstens einem Umlenkrad eingreifende "Verzahnung", so daß sich eine schlupffreie, sehr exakte Positionierung für die Halter allein durch einen schrittweisen Antrieb dieses Umlenkrades erzielen läßt.

Bei einer Ausführung der Erfindung ist die Transporteinrichtung Bestandteil einer Vorrichtung zum Ver-bzw. Bearbeiten elektrischer Bauelemente. "Ver- bzw. Bearbeiten" umfaßt im Sinne der Erfindung die unterschiedlichsten Ver-oder Bearbeitungsmöglichkeiten von Bauelementen, insbesondere auch das Trennen bzw. Vereinzeln von elektrischen Bauelementen, die an einem sogenannten Leadframe gebildet sind, das Umformen von Bauelementen hinsichtlich der Länge und/oder der Formgebung ihrer Anschlüsse, das Prüfen und/oder Messen und/oder Sortieren bzw. die gesteuerte Abgabe dieser Bauelemente an speziellen Abgabepositionen unter Berücksichtigung der zuvor an wenigstens einer Prüf- und Meßstation ermittelten Werte, das Einbringen der Bauelemente in Schächte bzw. Behälter einer Sortierstation, in Aufnahmen eines Gurtes usw.

Beim Ver- bzw. Bearbeiten von elektrischen Bauelementen werden diese bevorzugt in Form des Leadframes, beispielsweise eines Mehrfach-Leadframes an einer Aufgabestation in einer Achsrichtung senkrecht zur dortigen Transportrichtung des Transportbandes zugeführt.

Erfolgt an einer Abgabeposition, d.h. an einer Gurtstation ein Gurten der Bauelemente, so wird der Gurt dort ebenfalls in einer Achsrichtung senkrecht zur Transportrichtung zugeführt. Hierdurch ergibt sich eine besonders einfache Ausgestaltung der Aufgabe- und/oder Gurtstation. Um ein Messen der Bauelemente sowie ein Formen der Anschlüsse dieser Bauelemente zu ermöglichen, ist vorzugsweise wenigstens eine Wendestation vorgesehen, mit der die an den Haltern des Transportbandes gehaltenen Bauelemente derart gedreht werden, daß sie mit ihren Anschlüssen in einer Achsrichtung senkrecht zur Transportrichtung liegen. Vor dem Gurten werden Bauelemente dann vorzugsweise durch eine weitere Wendestation wiederum so gewendet, daß sie mit ihren Anschlüssen in Transportrichtung angeordnet sind und damit nach dem Einsetzen in die Ausnehmungen eines Gurtes mit den Anschlüssen senkrecht zur Gurtlängsrichtung liegen. Durch das erste Wenden ist ein besonders einfaches Messen der Bauelemente und/oder Formen der Anschlüsse möglich.

Die Bauelemente sind bevorzugt solche mit einem an der Ober-und Unterseite in etwa flächig ausgebildeten, vorzugsweise in etwa quaderförmigen Körper und mit vorzugsweise an zwei einander gegenüberliegenden Seiten von diesem Körper wegstehenden Anschlüssen.

Weiterbildungen der Erfindung sind Gegenstand der Unteransprüche.

Die Erfindung wird im folgenden anhand der Figuren an Ausführungsbeispielen näher erläutert. Es zeigen:
- Fig. 1: in sehr vereinfachter Darstellung und in Draufsicht einen Transporteur für Kleinst-Bauelemente gemäß der Erfindung, und zwar in seiner Verwendung bei einer Vorrichtung zum Ver- bzw. Bearbeiten von elektrischen Bauelementen;
- Fig. 2: in schematischer Darstellung und in Draufsicht eine Länge eines eine Vielzahl von elektrischen Bauelementen aufweisenden Doppel-Leadframe;
- Fig. 3: in Seitenansicht ein aus dem Leadframe durch Ausstanzen vereinzeltes Bauelement mit abgewinkelten Anschlüssen;
- Fig. 4: im Schnitt eine Länge eines geschlossenen Blister-Gurtes mit einem in eine Aufnahme dieses Gurtes angeordneten Bauelement;
- Fig. 5: in vereinfachter Darstellung die einzelnen Verfahrensschritte zwischen dem Ausstanzen der Bauelemente aus dem Leadframe und dem Einbringen der Bauelemente in Aufnahmebehälter oder in die Aufnahmen des Blister-Gurtes;
- Fig. 6: in Draufsicht eine Länge eines Transportbandes des Transporteurs;
- Fig. 7: einen Schnitt durch das Transportband im Bereich eines Umlenkrades bzw. entsprechend der Schnittlinie I-I der Fig. 1;
- Fig. 8: in schematischer Darstellung und in Seitenansicht einen Schnitt durch die Aufgabe- und Ausstanzstation;
- Fig. 9: in ähnlicher Darstellung wie Fig. 8 in einem Vertikalschnitt einen an dem Stahlband vorgesehenen Träger, zusammen mit dem dort vorgesehenen Halter, einer Führungsschiene sowie einer Vakuum-Versorgungsschiene bei einer weiteren Ausführungsform der Erfindung;
- Fig. 10: eine Draufsicht auf eine Länge der Transporteinrichtung der Fig. 9;
- Fig. 11: in vergrößerter Einzeldarstellung ein ein Halteelement bildende Schraube zur Verwendung bei dem Transporteur der Fig. 9.

In den Figuren ist 1 ein sogenannter Doppel-Leadframe, der in bekannter Weise als Stanzstreifen aus einem für Anschlußdrähte (Leads) elektrischer Bauelemente 5 geeigneten Metall bzw. Metallegierung hergestellt ist, und zwar derart, daß dieser Leadframe zwischen einem mittleren streifenförmigen Abschnitt 2 und jeweils einem äußeren, an den beiden Längsseiten bildenden streifenförmigen Abschnitt 3 bzw. 4 die Bauelemente 5 aufweist, die in jeweils gleichmäßigen Abständen in Längsrichtung des Leadframe 1 aufeinander folgend und über Materialstege 6, die die späteren Anschlüsse 7 (Leads) der elektrischen Bauelemente 5 bilden, mit den Abschnitten 2 und 3 bzw. 4 zu dem Leadframe miteinander verbunden sind. Die Bauelemente 5 bilden bei dem Doppel-Leadframe zwei sich in Längsrichtung erstreckende Reihen, und zwar beidseitig von dem mittleren Abschnitt 2, in welchem in gleichmäßigen Abständen Perforationslöcher 2' eingestanzt sind, die bei der Verarbeitung einen gesteuerten, schrittweisen exakten Vorschub des Leadframe 1 ermöglichen.

Die Bauelemente 5 werden mit der nachfolgend näher beschriebenen Vorrichtung aus dem Leadframe 1 ausgestanzt. Anschließend werden die Materialstege 6 zu Anschlüssen 7 derart S-oder Z-förmig gebogen, daß die Enden dieser Anschlüsse in etwa niveaugleich mit der Unterseite des Körpers 8 des jeweiligen Bauelementes 5 liegen. Schließlich werden die Bauelemente 5, die beispielsweise Transistoren, Tantal-Kondensatoren oder andere Bauelemente sind, gegurtet, d.h. jeweils in eine Vertiefung 9 eines Blister-Gurtes 10 eingesetzt, worauf dann dieser Gurt an der offenen Seite seiner Vertiefungen versiegelt, d.h. durch einen Materialstreifen 11 verschlossen wird. Alternativ zum Aufgurten können die Bauelemente 5 auch an einer Sortierstation nach ihren elektrischen Charakteristiken sortiert in unterschiedliche Behältnisse bzw. Kassetten abgegeben werden.

Das vorbeschriebene Verfahren wird an mehreren Arbeitspositionen ausgeführt, die im Bereich eines Transporteurs 12 vorgesehen sind, mit dem die Bauelemente 5 an den einzelnen Arbeitsstationen vorbeibewegt werden. Der Transporteur besteht, wie nachfolgend noch näher beschrieben wird, im wesentlichen aus einem geschlossenen, endlos getaktet angetriebenen Transportband 13, welches eine in der horizontalen Ebene liegende geschlossene Schlaufe bildet und hierfür über zwei Umlenkräder 14 und 15 geführt ist, von denen das Umlenkrad 15 getaktet angetrieben ist.

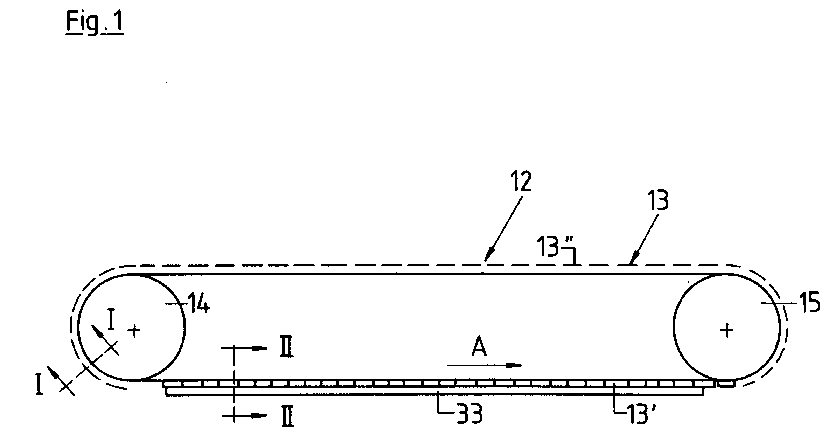

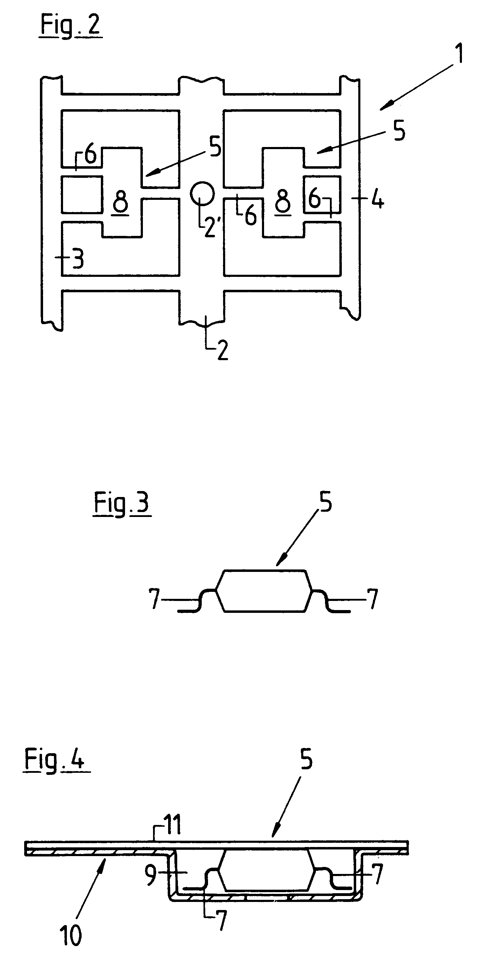

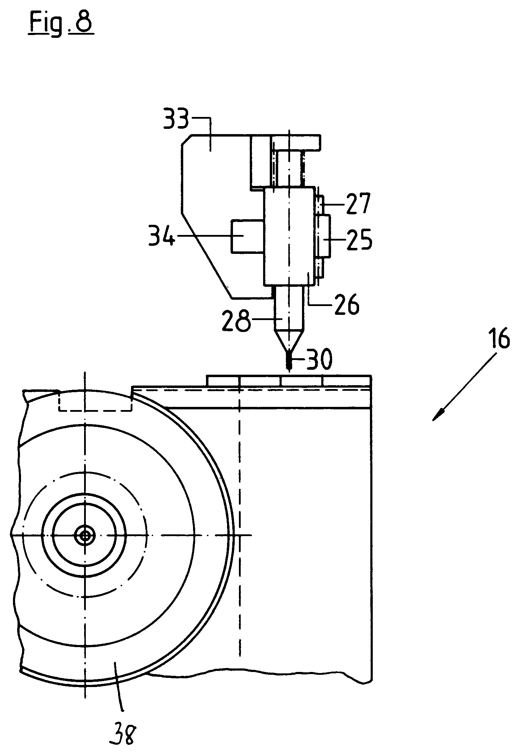

Bei der in den Figuren 1 bis 18 dargestellten Ausführungsform bildet das Transportband 13 eine Länge 13', an der sich die verschiedenen Arbeitsstationen befinden und die daher als "Arbeitslänge" bezeichnet werden kann, und eine rückführende Länge 13''.

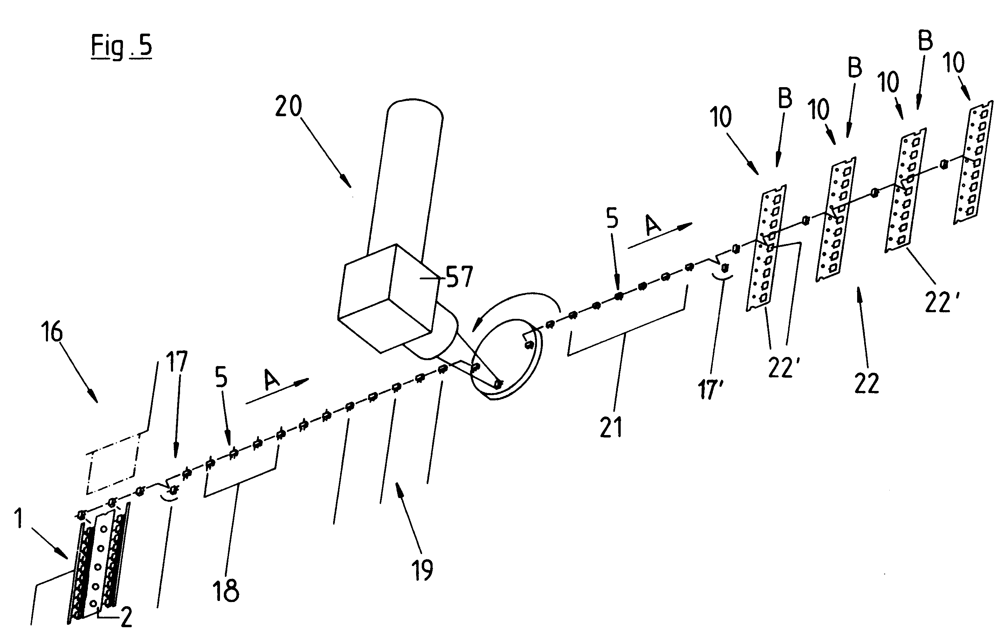

Entsprechend der schematischen Darstellung der Fig. 5 befinden sich an der Arbeitslänge 13' in Umlauf- bzw. Transportrichtung A des Transportbandes 13 aufeinander folgend folgende Arbeitsstationen:
Aufgabestation 16
Wendestation 17
Meßstation 18
Biegestation 19
Laser-Markierungsstation 20
Sortierstation 21 und
Gurtstation 22.

Wie vorstehend bereits beschrieben, besteht der Transporteur 12 im wesentlichen aus dem endlosen Transportband 13, welches über die beiden Umlenkräder 14 und 15 geführt ist. Das Umlenkrad 15 ist dabei über ein spezielles Takt-Getriebe von dem für sämtliche Elemente der Maschine gemeinsamen Antrieb getaktet angetrieben.

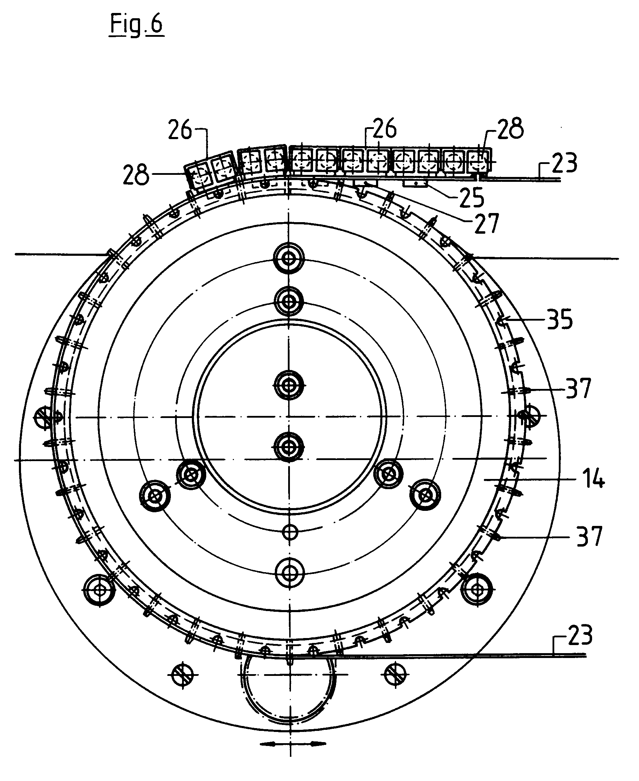

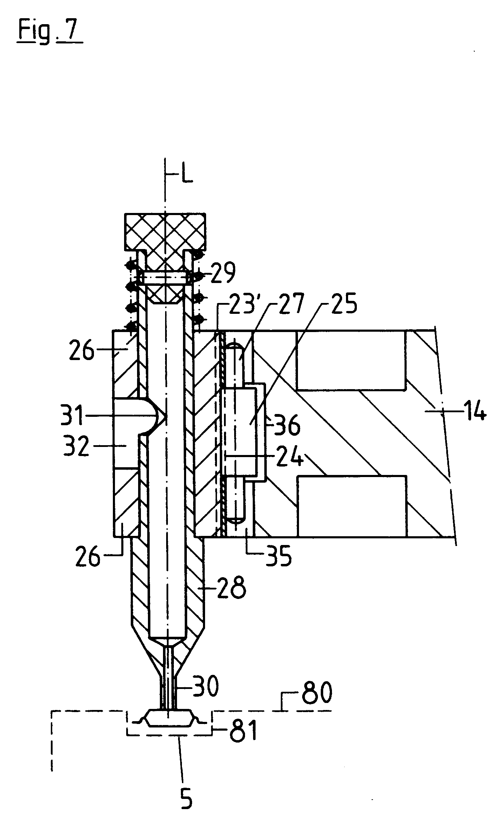

Wie speziell in den Figuren 6 und 7 dargestellt ist, besteht das Transportband 13 aus einem Stahlband 23, welches hochkant, d.h. mit seinen größeren Oberflächenseiten in vertikalen Ebenen angeordnet und mit seinen beiden Enden zu einem geschlossenen Band verbunden ist. In dem Stahlband 23 sind in gleichmäßigen Abständen jeweils größere von der Kreisform abweichende, d.h. bei der dargestellten Ausführungsform quadratische Öffnungen 24 vorgesehen. Durch jede Öffnung greift ein dem Querschnitt dieser Öffnung angepaßter Ansatz 25 hindurch, der an der Rückseite eines als quaderförmiger Klotz ausgebildeten Trägers vorgesehen ist. Die Träger 26 sind mit Hilfe ihrer Ansätze 25 an der außen liegenden Seite der vom Stahlband 23 gebildeten Schlaufe vorgesehen, und zwar derart, daß in den geradlinigen Längen 13' und 13'' benachbarte Träger 26 mit ihren senkrecht zur Transportrichtung A verlaufenden Stirnflächen dicht gegeneinander anliegen. Jeder Träger 26 ist mit Hilfe eines Splintes bzw. Stiftes 27, der an der innen liegenden Seite der vom Stahlband 23 gebildeten Schlaufe gegen das Stahlband anliegt und im Ansatz 25 vorgesehen ist, gesichert. Jeder Stift 27 liegt mit seiner Achse in vertikaler Richtung, d.h. parallel zur Drehachse der Umlenkräder 14 und 15 und damit auch senkrecht zur Transportrichtung A.

In Transportrichtung A aufeinander folgend sind an jedem Träger 26 zwei als Vakuum-Pipetten ausgebildete Halter 28 für die Bauelemente 5 vorgesehen. Die Halter 28 sind jeweils in einer Achsrichtung senkrecht zur Transportrichtung A und parallel zur Achse der Umlenkräder 14 und 15 in Richtung ihrer Längsachse L gegen die Wirkung einer Druckfeder 29 aus einer angehobenen Stellung in eine abgesenkte Stellung verschiebbar. Die Halter 28, die gleichartig ausgebildet sind, bestehen im wesentlichen aus einem an seiner Oberseite dicht verschlossenen Rohrstück, welches an seiner Unterseite in einen im Außen- und Innenquerschnitt saugdüsenartig bzw. pipettenartig verengten Abschnitt 30 übergeht. Über Öffnungen 31 und 32 im Halter 28 bzw. im Träger 26 steht im Bereich der Arbeitslänge 13' jeder dort vorhandene Halter 28 mit einem an einer Vakuum-Verteilerkammer 34, die an einer sich mit dem Transportband 13 nicht mitbewegenden Führungsschiene 33 ausgebildet ist und einen Längsschlitz aufweist, in Verbindung, so daß jeder Halter 28, solange er sich entlang der Arbeitslänge 13' bewegt, mit Vakuum beaufschlagt ist und an seinem Abschnitt 30 bzw. an der dortigen Öffnung ein Bauelement 5 an dessen Körper 8 halten kann, wie dies in der Fig. 7 angedeutet ist.

Die beiden Umlenkräder 14 und 15 sind an ihrem Umfang mit einer Vielzahl von Ausnehmungen 35 versehen, deren Teilungsabstand gleich dem Abstand zweier in Transportrichtung A aufeinander folgender Stifte 27 ist und in die auf der um die Umlenkräder 14 und 15 geführten Längen des Transportbandes die Stifte 27 mit ihren oberen und unteren, über den Ansatz 25 vorstehenden Teillängen eingreifen. Es versteht sich, daß die Ausnehmungen 35 jeweils paarweise beidseitig von einer Umfangsnut 36 des Umlenkrades 14 bzw. 15 vorgesehen sind, die (Umfangsnut 36) zur Aufnahme der Ansätze 25 dient. Durch die mit den Ausnehmungen 35 zusammenwirkenden Stifte 27 ist eine ketten- oder zahnriemenartige exakte Positionierung des Transportbandes 23 in Abhängigkeit von der jeweiligen Winkelstellung der Umlenkräder 14 und 15 möglich, so daß in Verbindung mit dem Stahlband 23 auch auf einem einen relativ großen Arbeitsbereich bzw. einer relativ großen Arbeitslänge 13' eine sehr exakte Positionierung der einzelnen Halter 28 an den jeweiligen Arbeitsstationen mit äußerst geringen Toleranzen erreichbar ist, also trotz der geringen Abmessungen der Bauelemente 5 bzw. deren Körper 8, die in der Größenordnung von 1 bis 2 mm liegen, eine gesonderte Indexierung der Träger 26 bzw. der Halter 28 an den Arbeitsstationen nicht erforderlich ist.

Bei der speziellen, dargestellten Ausführungsform sind zusätzlich zu den Ausnehmungen 35 an den Umlenkrädern 14 und 15 noch über den Umfang dieser Räder radial vorstehende Stifte 37 vorgesehen, die in entsprechende Perforationslöcher des Transportbandes 13 bzw. Stahlbandes 23 eingreifen.

Die beiden Enden des Stahlbandes 23 sind dadurch verbunden, daß an jedem Ende ein Träger 26 gehalten ist und diese beiden Träger dann über eine eine Verbindungslasche bildende kurze Länge 23' des Stahlbandes 23 miteinander verbunden sind. In diesem Bereich ist dann an jedem Ansatz 25 das Stahlband 23 und die verbindende Länge 23' gehalten, wobei die verbindende Länge 23' an der Außenseite der vom Stahlband 23 gebildeten Schlaufe liegt und die beiden an der Verbindungsstelle vorgesehenen Träger 26 in einer Achsrichtung senkrecht zu den Oberflächenseiten des Stahlbandes 23 eine um die Dicke des Stahlbandes 23 bzw. der Länge 23' reduzierte Breite aufweisen. Hierdurch ergeben sich an der Innenseite der Schlaufe des Transportbandes 13 auch im Bereich der Verbindungsstelle die gleichen Verhältnisse wie im restlichen Teil des Transportbandes 13, so daß auch dann, wenn die Verbindungsstelle eines der Umlenkräder 13 und 15 passiert, eine die Positionsgenauigkeit der Halter 28 beeinträchtigende Änderungen im Transportband 13 auftreten.

Der Aufgabestation 16 wird von einer Vorratsspule 38 der Leadframe 1 getaktet zugeführt. Mittels eines Stanzwerkzeuges werden dort aus dem Leadframe 1 die Bauelemente 5 so ausgestanzt, daß die Metallstege 6 an dem Bauelementkörper verbleiben und die Anschlüsse 7 bilden.

Jedes Bauelement 5 wird von einem abgesenkten und mit dem Vakuum beaufschlagten Halter 28 erfaßt und dann von dem angehobenen Halter 28 (durch das Vakuum gehalten) von der Aufgabestation 16 über die verschiedenen weiteren Stationen schließlich entweder an die Sortierstation 21 oder an die Gurtstation 22 transportiert. In der Sortierstation 21 werden die Bauelemente nach elektrischen Meßwerten sortiert in unterschiedliche Ablagen abgelegt. An der Gurtstation 22 werden die Bauelemente 5 in die Vertiefungen 9 der dort bereitstehenden Gurte 10 eingelegt, und zwar jeweils ein Bauelement 5 in eine Vertiefung 9. Das Einbringen eines Bauelementes 5 in eine Vertiefung 9 erfolgt durch vertikales Absenken des Halters 28. Nach dem Einführen eines Bauelementes 5 in eine Vertiefung 9 wird der Halter 28 wieder angehoben. Hierbei wird durch einen Schieber oder Abstreifer das Bauelement 5 in der Vertiefung zurückgehalten.

An der Wendestation 17 erfolgt ein Wenden der Bauelemente 5 derart, daß die Anschlüsse 7 eine vorgegebene Orientierung aufweisen, z.B. senkrecht zur Transportrichtung A liegen. An der Meßstation 18 erfolgt das Messen der Bauelemente 5. An der Biegestation 19 erfolgt ein Biegen der Anschlüsse 7 in die erforderliche Form. An der Laser-Markierungsstation 20 erfolgt ein Markieren bzw. Bedrucken der Bauelemente 5.

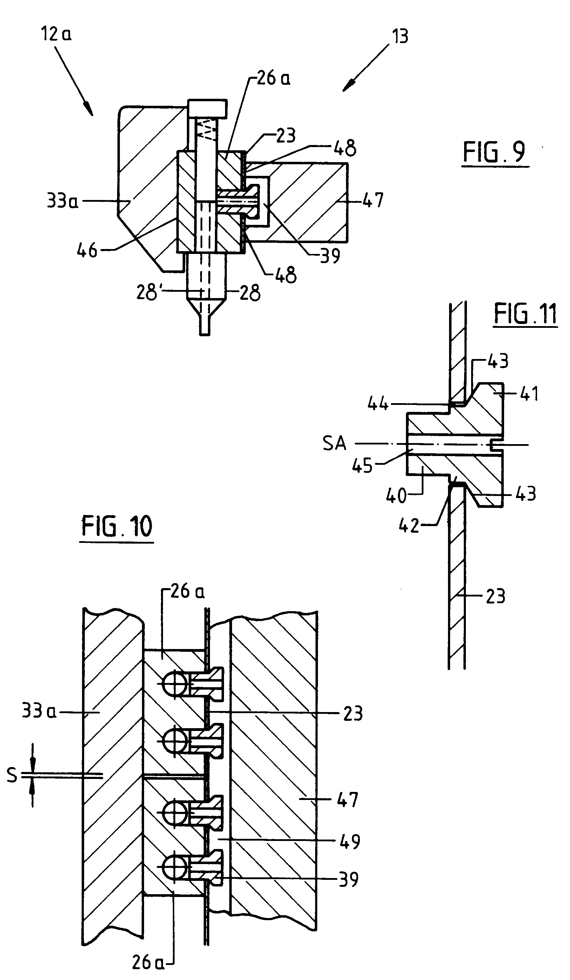

In der Fig. 9 - 11 ist als weitere Ausführungsform eine Transporteinrichtung 12a dargestellt, die sich von der Transporteinrichtung 12 im wesentlichen durch die Ausbildung der am Transportband 13 bzw. Stahlband 23 vorgesehenen Träger 26a sowie durch die Halterung dieser Träger am Stahlband 23 unterscheidet. Ansonsten entspricht der Transporteur 12a dem Transporteur 12 und für entsprechende Teile sind in den Figuren 9 - 11 wieder die gleichen Bezugsziffern verwendet wie in den Figuren 1 - 8.

Die Träger 26a, die in dichtem Abstand voneinanderfolgend am Transportband 13 bzw. an dem Stahlband 23 vorgesehen sind, sind wiederum quaderförmig ausgebildet und mit Hilfe jeweils zweier Schrauben 39 am Stahlband 23 gehalten. An jedem Träger 26a sind zwei pipettenartige Halter 28 vorgesehen, und zwar jeweils in vertikaler Richtung verschiebbar und durch die Druckfeder 29 in die angehobene Stellung vorgespannt.

Die Träger 26a befinden sich wieder (bezogen auf die von dem Stahlband 23 gebildeten Schlaufe) an der Außenseite dieses Stahlbandes. Die Schrauben 39 besitzen, wie in der Fig. 11 besonders deutlich dargestellt ist, einen Schaft-oder Gewindeabschnitt 40, einen Schraubenkopf 41 sowie einen zwischen dem Schraubenkopf 41 und dem Gewindeabschnitt 40 vorgesehenen Bund 42, der eine die Schraubenachse SA konzentrisch umschließende kreiszylinderförmige Fläche bildet. An der dem Gewindeabschnitt 40 und dem Bund 42 zugewandten Seite ist die dortige Fläche 43 des Schraubenkopfes 41 konvex gestaltet, d.h. die Fläche 43 ist eine Kegelfläche oder eine ballige, konvex gekrümmte Fläche eines Rotationskörpers mit der Achse SA.

In dem Stahlband 23 sind Öffnungen 44 vorgesehen, deren Querschnitt geringfügig größer ist als der Durchmesser der Schrauben 39 im Bereich des Bundes 42. Zwei Öffnungen 44 bilden ein Öffnungspaar und zwei Schrauben 39 ein Schraubenpaar für einen Träger 26a. Der Abstand der Öffnungen 44 jedes Öffnungspaares ist so gewählt, daß jede der beiden Schrauben 39, die in Transportrichtung A gegeneinander versetzt angeordnet und mit ihren Schraubenachsen SA senkrecht zum hochkant stehenden Stahlband 23 bzw. zur Transportrichtung A orientiert sind, auf den geradlinigen Längen 13' und 13'' des Transportbandes 13 mit der der jeweils anderen Schraube 39 abgewandten Seite des Bundes 42 dicht gegen den Rand der zugehörigen Öffnung 44 anliegt, während an der der jeweils anderen Schraube 39 eines Schraubenpaares zugewandten Seite des Bundes 42 ein geringfügiger Abstand zwischen diesen Bund und dem Rand der Öffnung 44 besteht. Hierdurch wird einerseits erreicht, daß auf jeden Fall in den geradlinigen Abschnitten 13' und 13'' des Transporteurs 12a die Träger 26a exakt in bezug auf das Stahlband 23 positioniert sind, außerdem aber auch ein Umlenken des Stahlbandes 23 an den Umlenkrädern 14 und 15 möglich ist.

Die Schrauben 39, die mit ihrem Gewindeabschnitt 40 jeweils in ein Gewinde des betreffenden Trägers 26a eingreifen, sind mit einem beidendig offenen axialen Kanal 45 versehen. Dieser Kanal 45 steht mit dem in dem jeweiligen Halter 28 gebildeten Kanal 28' in Verbindung.

Die Figuren 9 und 10 zeigen eine der Führungsschiene 33 entsprechende Führungsschiene 33a, die eine Führungsnut 46 bildet, in der die Träger 26a mit ihrer dem Stahlband 23 abgewandten Seite geführt ist und die die Träger 26a teilweise auch an ihrer Oberseite und Unterseite führt. Der Führungsschiene 33a gegenüberliegend ist eine Führungsschiene 47 vorgesehen, die sich parallel zur Führungsschiene 33a in Transportrichtung A erstreckt und gegen die das Stahlband 23 mit seiner den Trägern 26a abgewandten Innenseite anliegt bzw. für diese Seite des Stahlbandes 23 eine Führungsfläche 48 bildet. Im Bereich der Führungsfläche 48 ist ein nutenartiger Vakuumverteilerkanal 49 gebildet, dessen der Führungsschiene 33a zugewandte offene Seite vollständig durch das Stahlband 23 abgedeckt ist und in welchem die Schrauben 39 mit ihrem Schraubenkopf 41 hineinreichen, so daß über diesen Vakuum-verteilerkanal 49 und die in diesem Kanal mit ihrem Schraubenkopf 41 befindlichen Schrauben 39 die zugehörigen Halter 28 mit Vakuum beaufschlagt werden. Dadurch, daß der Kanal 49 durch das Stahlband 23 abgedeckt ist, werden Vakuum-Verluste weitgehend vermieden. An den beiden Enden des Kanals 49 sind beispielsweise schleusenartig wirkende Dichtungselemente, beispielsweise lamellenartige Dichtungselemente vorgesehen.

Durch die konvexe Ausbildung der Flächen 43, mit denen die Schrauben 39 gegen die innenliegende Seite des Stahlbandes 23 anliegen, wird auch bei dieser Ausführung wiederum sichergestellt, daß das Stahlband 23 über die Umlenkräder 14 und 15 geführt werden kann, ohne daß Knicke im Stahlband auftreten. Die Schraubenköpfe 41 dienen wiederum als in wenigstens ein Umlenkrad 14 und 15 eingreifende Verzahnung.

Die Erfindung wurde voranstehend an Ausführungsbeispielen beschrieben. Es versteht sich, daß Änderungen sowie Abwandlungen möglich sind.

### Aufstellung der Bezugsziffern

- 1: Leadframe
- 2, 3, 4: Abschnitt
- 2': Perforationsöffnung
- 5: Bauelement
- 6: Materialsteg
- 7: Anschluß
- 8: Körper
- 9: Vertiefung
- 10: Gurt
- 11: Materialstreifen
- 12, 12a: Transporteur
- 13: Transportband
- 13', 13'': Längen
- 14, 15: Umlenkrad
- 16: Aufgabestation
- 17, 17': Wendestation
- 18: Meßstation
- 19: Biegestation
- 20: Laser-Markierungsstation
- 21: Sortierstation
- 22: Gurtstation
- 23: Stahlband
- 23': Länge
- 24: Öffnung
- 25: Ansatz
- 26, 26a: Träger
- 27: Stift
- 28: Halter
- 29: Feder
- 30: Abschnitt
- 31, 32: Öffnung
- 33, 33a: Führungsschiene
- 34: Vakuum-Kanal
- 35: Ausnehmung
- 36: Umfangsnut
- 37: Stift
- 38: Vorratsspule
- 39: Schraube
- 40: Gewindeabschnitt
- 41: Schraubenkopf
- 42: Bund
- 43: Fläche
- 44: Öffnung
- 45: Kanal
- 46: Führungsnut
- 47: Führungsschiene
- 48: Führungsfläche
- 49: Vakuum-Verteilerkanal

## Patentansprüche

1. Transporteinrichtung zum Transportieren von vorzugsweise elektrischen Bauelementen (5), die (Transporteinrichtung) ein über wenigstens zwei Umlenkräder (14, 15) geführtes, eine in sich geschlossene Schlaufe bildendes Transportmittel sowie an diesem angeordnete Halter (28) zum Aufnehmen der Bauelemente (5) aufweist, wobei das Transportmittel ein Metallband ist, an dem die Halter (28) aufnehmende Träger (26, 26a) angeordnet sind, **dadurch gekennzeichnet,** daß die Träger (26, 26a) an der bezogen auf die Schlaufe außenliegenden Seite des Metallbandes (23) angeordnet und von innen jeweils durch wenigstens ein Halteelement (27, 39) gehalten sind, welches mit einem um eine Achse senkrecht zur Transportrichtung (A) sowie parallel zur Bandoberfläche konvex geformten Bereich gegen die innenliegende Fläche des Metallbandes (23) anliegt.

2. Transporteinrichtung nach Anspruch 1, dadurch gekennzeichnet, daß die Halter (28) an den Trägern (26, 26a) verschiebbar vorgesehen sind.

3. Transporteinrichtung nach Anspruch 1 oder 2, dadurch gekennzeichnet, daß das Metallband (23) ein Stahlband ist.

4. Transporteinrichtung nach einem der Ansprüche 1 bis 3, dadurch gekennzeichnet, daß die Halter Zangen sind.

5. Transporteinrichtung nach einem der Ansprüche 1 bis 4, dadurch gekennzeichnet, daß wenigstens eine mit dem Transporband (13) sich nicht mitbewegende Führungsschiene (33, 47) für die Träger (26, 26a) sowie ein in dieser ausgebildeter Vakuum-Verteilerkanal (34, 49) für die als Vakuumhalter (28) ausgebildeten Halter vorgesehen sind.

6. Transporteinrichtung nach einem der Ansprüche 1 bis 5, dadurch gekennzeichnet, daß die Träger (26, 26a) in senkrecht zur Transportrichtung (A) verlaufenden Ebenen zumindest während ihrer geradlinigen Bewegung aneinander anliegen.

7. Transporteinrichtung nach einem der Ansprüche 1 - 6, dadurch gekennzeichnet, daß das Halteelement (27, 39) an seinem gegen die innenliegende Fläche des Metallbandes (23) anliegenden Bereich um eine Achse senkrecht zur Transportrichtung sowie parallel zur Bandoberfläche konvex ausgebildet ist.

8. Transporteinrichtung nach einem der Ansprüche 1 - 7, dadurch gekennzeichnet, daß das Halteelement (27, 39) konvex gekrümmt ist.

9. Transporteinrichtung nach einem der Ansprüche 1 bis 8, dadurch gekennzeichnet, daß der konvex gekrümmte, gegen die innenliegende Fläche des Metallbandes (23) anliegende Bereich jedes Halteelementes von einem in einem Ansatz (25) des Trägers (26) gehaltenen stift- oder hülsenartigen Element (27) gebildet ist.

10. Transporteinrichtung nach einem der Ansprüche 1 - 8, dadurch gekennzeichnet, daß das Halteelement von einem Zapfen oder einer Schraube (39) mit einem Kopf (41) gebildet ist, der an einer Innenfläche (43) konvex ausgebildet ist und gegen die innenliegende Fläche des Metallbandes (23) anliegt.

11. Transporteinrichtung nach einem der Ansprüche 1 bis 10, dadurch gekennzeichnet, daß das Metallband (23) zur Herstellung des Endlosbandes an beiden Enden jeweils mit einem Träger (26, 26a) versehen ist, und daß diese beiden Träger (26, 26a) durch eine laschenartige Länge (23') eines, vorzugsweise des gleichen Metallbandes (23) miteinander verbunden sind.

12. Transporteinrichtung nach einem der Ansprüche 1 bis 11, dadurch gekennzeichnet, daß die Halteelemente (27, 39) für die Träger (26, 26a) in Ausnehmungen (35) wenigstens eines Umlenkrades (14, 15) eingreifen.

13. Transporteinrichtung nach einem der Ansprüche 1 bis 12, dadurch gekennzeichnet, daß an wenigstens einem Umlenkrad (14, 15) Index-Stifte (37) vorstehen, die in Perforationsöffnungen des Metallbandes (23) eingreifen.

14. Transporteinrichtung nach einem der Ansprüche 1 bis 13, dadurch gekennzeichnet, daß an jedem Träger (26a) mehrere, vorzugsweise zwei Halter (28) vorgesehen sind.

15. Transporteinrichtung nach einem der Ansprüche 1 bis 14, dadurch gekennzeichnet, daß die Transporteinrichtung Bestandteil einer Vorrichtung zum Ver- und Bearbeiten von elektrischen Bauelementen (5) ist, die wenigstens eine Aufgabestation (16), an der die Bauelemente (5) jeweils nacheinander an die sich an dieser Station getaktet vorbeibewegenden Halter (28) übergeben werden, sowie wenigstens eine Abgabe- oder Entnahmestation (21, 22) für die Bauelemente besitzt.

16. Transporteinrichtung nach einem der Ansprüche 5 - 15, dadurch gekennzeichnet, daß die den Vakuum-Verteilerkanal (49) aufweisende Führungsschiene (47) an der den Trägern (26a) abgewandten innenliegenden Seite des Metallbandes (23) vorgesehen ist und für diese innenliegende Seite des Metallbandes (23) eine Führungsfläche (48) bildet, daß der Vakuum-Verteilerkanal (49) eine zum Metallband (23) hin offene Seite aufweist, die von dem Metallband (23) abgedeckt ist, und daß der Vakuum-Verteilerkanal (49) durch wenigstens eine Öffnung oder einen Kanal (45) im Stahlband (23) und/oder im Halteelement (39) mit dem Vakuumhalter (28) bzw. einem dort ausgebildeten Kanal (28') in Verbindung steht.

## Claims

1. Conveyor for the transportation of preferably electrical components (5) the (conveyor) having a closed loop forming transport means guided by at least two deflection wheels (14, 15) as well as holders (28) arranged on this to contain the components (5) whereby the transport means is a metal band on which the holder (28) accommodating supports (26, 26a) are arranged, characterised in that the supports (26, 26a) are arranged on the outer side of the metal bands (23) with respect to the loop and each are held from the inside by at least a holding element (27, 39), which with an area formed convexly around an axis perpendicular to the transport direction (A) as well as parallel to the band upper surface lies closely against the inner surface of the metal band (23).

2. Conveyor according to claim 1 characterised in that the holders (28) are movably provided on the supports (26, 26a).

3. Conveyor according to claim 1 or claim 2 characterised in that the metal band (23) is a steel band.

4. Conveyor according to one of claims 1 to 3 characterised in that the holders are grippers.

5. Conveyor according to one of claims 1 to 4 characterised in that at least one guide rail (33, 47) for the supports (26, 26a), itself not moving with the transport band (13), as well as a vacuum distributor canal (34, 49) formed in this for the holder formed as a vacuum holder (28) are provided.

6. Conveyor according to one of claims 1 to 5 characterised in that the supports (26, 26a) fit closely to one another perpendicular to the plane containing the transport direction (A) at least during their linear movement.

7. Conveyor according to one of claims 1 to 6 characterised in that the holding element (27, 39) against the inner surface of the metal band (23) adjacent area is convexly formed around an axis perpendicular to the transport direction as well as parallel to the band upper surface.

8. Conveyor according to one of claims 1 to 7 characterised in that the holding element (27, 39) is curved convexly.

9. Conveyor according to one of claims 1 to 8 characterised in that the convexly curved against the inner surface of the metal band (23) located area of each holding element is formed from a pin or barrel element (27) held in a projection (25) of a support (26).

10. Conveyor according to one of claims 1 to 8 characterised in that the holding element is formed from a stud or a screw (39) with a head (41) which is formed convexly on an inner surface (43) and fits closely against the inner surface of the metal band (23).

11. Conveyor according to one of claims 1 to 10 characterised in that the metal band (23) for the production of a continuous band is provided at both ends, each with a support (26, 26a) and that both the supports (26, 26a) are connected with one another through a bracket like length (23') of a preferably of the same metal band.

12. Conveyor according to one of claims 1 to 11 characterised in that the holding elements (27, 39) for the supports (26, 26a) engage in recesses (35) of at least one deflection wheel (14, 15).

13. Conveyor according to one of claims 1 to 12 characterised in that on at least one deflection wheel (14, 15), index pins (37) project which engage in perforation openings of the metal band (23).

14. Conveyor according to one of claims 1 to 13 characterised in that on each support (26a) several, preferably two, holders (28) are provided.

15. Conveyor according to one of claims 1 to 14 characterised in that the conveyor is a component of an apparatus for the processing and treating of electrical components (5) which has at least a supply station (16) to which the components (5) are delivered, each one after the other, on the holder (28) itself clocked and moving by this station as well as at least a delivery or removal station (21, 22) for the components.

16. Conveyor according to one of claims 5 to 15 characterised in that the guide rail (47) having the vacuum distributor canal (49) is provided on the inner side of the metal band (23) opposite the supports (26, 26a) and forms for this inner side of the metal band (23) a guide surface (48), that the vacuum distributor canal (49) has a side open to the metal band (23) which is covered by the metal band (23) and that the vacuum distributor canal (49) through at least an opening or a channel (45) in the steel band (23) and/or in the holding element (39) remains in connection with the vacuum holder (28) or a channel (28') thereformed.

## Revendications

1. Convoyeur pour le transport de composants (5) de préférence électriques, qui présente un moyen de transport guidé par au moins deux roues de renvoi (14, 15) et formant une boucle une boucle fermée sur elle-même et des fixations (28) disposées sur ce moyen de transport pour recevoir les composants (5), le moyen de transport étant une bande métallique sur laquelle sont disposés les supports (26, 26a) recevant les fixations (28), caractérisé en ce que les supports (26, 26a) sont disposés sur le côté de la bande métallique (23) extérieur par rapport à la boucle et sont maintenus de l'intérieur respectivement par au moins un élément de retenue (27, 39), lequel touche, avec une zone formée de façon convexe autour d'un axe perpendiculairement au sens de transport (A) et parallèlement à la surface de la bande, la surface intérieure de la bande métallique (23).

2. Convoyeur selon la revendication 1, caractérisé en ce que les fixations (28) sont prévues de façon coulissante sur les supports (26, 26a).

3. Convoyeur selon la revendication 1 ou 2, caractérisé en ce que la bande métallique (23) est un feuillard d'acier.

4. Convoyeur selon l'une quelconque des revendications 1 à 3, caractérisé en ce que les fixations sont des pinces.

5. Convoyeur selon l'une quelconque des revendications 1 à 4, caractérisé en ce qu'on prévoit au moins un rail de guidage (33, 47) qui ne se déplace pas avec la bande transporteuse (13) pour les supports (26, 26a) et un canal répartiteur de vide (34, 49) réalisé dans celui-ci pour les fixations réalisées comme des éléments de maintien du vide (28).

6. Convoyeur selon l'une quelconque des revendications 1 à 5, caractérisé en ce que les supports (26, 26a) se touchent dans des plans perpendiculaires au sens de transport (A) au moins pendant leur déplacement en ligne droite.

7. Convoyeur selon l'une quelconque des revendications 1 à 6, caractérisé en ce que l'élément de retenue (27, 39) est réalisé de façon convexe sur sa zone touchant la surface intérieure de la bande métallique (23) autour d'un axe perpendiculairement au sens de transport et parallèlement à la surface de la bande.

8. Convoyeur selon l'une quelconque des revendications 1 à 7, caractérisé en ce que l'élément de retenue (27, 39) est courbé de façon convexe.

9. Convoyeur selon l'une quelconque des revendications 1 à 8, caractérisé en ce que la zone de chaque élément de retenue courbée de façon convexe et touchant la surface intérieure de la bande métallique (23) est constituée d'un élément (27) du type broche ou douille maintenu dans une embase (25) de la poutre (26).

10. Convoyeur selon l'une quelconque des revendications 1 à 8, caractérisé en que l'élément de retenue est constitué d'un tenon ou d'une vis (39) avec une tête (41) qui est réalisée de façon convexe sur une surface intérieure (43) et touche la surface intérieure de la bande métallique (23).

11. Convoyeur selon l'une quelconque des revendications 1 à 10, caractérisé en ce que la bande métallique (23) est pourvue aux deux extrémités respectivement d'un support (26, 26a) pour la fabrication de la bande sans fin, et en ce que ces deux supports (26, 26a) sont reliés entre eux par une longueur (23') en forme d'éclisse d'une bande métallique (23), de préférence de la même bande métallique.

12. Convoyeur selon l'une quelconque des revendications 1 à 11, caractérisé en ce que les éléments de retenue (27, 39) pour les supports (26, 26a) rentrent dans des évidements (35) d'au moins une roue de renvoi (14, 15).

13. Convoyeur selon l'une quelconque des revendications 1 à 12, caractérisé en ce que sur au moins une roue de renvoi (14, 15) dépassent des broches à index (37) qui rentrent dans les orifices de perforation de la bande métallique (23).

14. Convoyeur selon l'une quelconque des revendications 1 à 13, caractérisé en ce que plusieurs, de préférence deux fixations (28) sont prévues sur chaque support (26a).

15. Convoyeur selon l'une quelconque des revendications 1 à 14, caractérisé en ce que le convoyeur est un élément constituant d'un dispositif pour le traitement et l'usinage de composants (5) électriques qui a au moins une station d'alimentation (16), sur laquelle les composants (5) sont transmis respectivement de façon successive aux fixations (28) passant de façon synchronisée sur cette station, et au moins une station de distribution ou de prélèvement (21, 22) pour les composants.

16. Convoyeur selon l'une quelconque des revendications 5 à 15, caractérisé en ce que le rail de guidage (47) présentant le canal distributeur de vide (49) est prévu sur le côté de la bande métallique (23) opposé aux poutres (26a) et forme une surface de guidage (48) pour ce côté intérieur de la bande métallique (23), en ce que le canal distributeur de vide (49) présente un côté ouvert vers la bande métallique (23) qui est masqué par la bande métallique (23) et en ce que le canal répartiteur de vide (49) est en liaison par au moins une ouverture ou un canal (45) dans le feuillard d'acier (23) et/ou dans l'élément de retenue (39) avec l'élément de maintien du vide (28) et un canal (28') réalisé à cet endroit.
